# EUROPEAN PATENT APPLICATION

(11) **EP 4 428 948 A1**
(43) Date of publication of application: **11.09.2024**
(21) Application number: 22909192.1
(22) Date of filing: 23.06.2022
(51) Int. Cl.: H01M 4/36

(54) **COMPOSITE MATERIAL FOR SECONDARY LITHIUM-ION BATTERY, AND PREPARATION METHOD THEREFOR AND USE THEREOF**

(30) Priority: 22.12.2021 CN 202111582639
(71) Applicant: Tianmulake Excellent Anode Materials Co, Ltd., Liyang, Jiangsu 213330 (CN)
(72) Inventor: JI, Xiang, Liyang, Jiangsu 213300 (CN); SHAO, Jin, Liyang, Jiangsu 213300 (CN); LUO, Fei, Liyang, Jiangsu 213300 (CN)
(74) Representative: Glück Kritzenberger Patentanwälte PartGmbB
(86) International application number: PCT/CN2022/100702
(87) International publication number: WO 2023/115860

(57) **Abstract**

The present invention relates to a composite material for a secondary lithium-ion battery, and a preparation method therefor and the use thereof. The composite material for a secondary lithium-ion battery is such that: the interior thereof is a spherical porous hard carbon material having hollow holes, and a product resulting from the decomposition and deposition of a silicon-containing gas and one or more gaseous compounds containing any element of C, N, B and P are deposited in the pores, wherein the product comprises silicon nanoparticles, and the porous hard carbon material is obtained by means of curing a hard carbon matrix using a double emulsion method and then carbonizing same.

## Description

The application claims the priority of Chinese patent application No. 202111582639.1, entitled "COMPOSITE MATERIAL FOR SECONDARY LITHIUM-ION BATTERY, AND PREPARATION METHOD THEREFOR AND USE THEREOF", filed with the China National Intellectual Property Administration on December 22, 2021.

### BACKGROUND OF THE INVENTION

### 1. Technical Field

The present invention relates to the technical field of materials, in particular to a composite material for a secondary lithium-ion battery, and a preparation method therefor and the use thereof.

### 2. Description of Related Art

The reason why silicon is considered an ideal negative electrode material for high-capacity lithium-ion batteries largely lies in its theoretical specific capacity of 4200 mAh/g, which is an order of magnitude higher than that of traditional graphite negative electrodes of 372 mAh/g. However, the high capacity of lithium-ion batteries is accompanied by a 300% volume expansion of the silicon negative electrodes during the lithium intercalation process, resulting in numerous electrode fractures and capacity fade of the battery.

Currently, the preparation of silicon-carbon composite materials is being used to effectively mitigate the issues caused by volume effect. For instance, in patent CN201510448316.1, silicon and various carbon materials are mechanically mixed twice and then spray-dried; subsequently, a carbon shell is deposited through vapor deposition on the outermost layer, alleviating the expansion problem of silicon to some extent. Nevertheless, most existing methods primarily involve mechanical mixing or simple coating techniques, resulting in uneven distribution of nano-silicon particles within the carbon materials. As a consequence, the full potential of silicon-carbon composite materials cannot be fully realized. Additionally, this method fails to effectively solve the material damage caused by the high expansion of silicon.

### BRIEF SUMMARY OF THE INVENTION

Embodiments of the present invention provide a composite material for a secondary lithium-ion battery, and a preparation method therefor and the use thereof. In the composite material, nano-silicon and one or more gaseous compounds containing any chemical element of carbon C, nitrogen N, boron B and phosphorus P are uniformly distributed in the pores of spherical porous carbon by vapor deposition. On one hand, the porous structure can limit the size and uniform dispersion of deposited nano-silicon particles, reduce the expansion effect and avoid the problem of electrical contact deterioration caused by silicon pulverization. On the other hand, the presence of large holes at the center provides a substantial buffer space for accommodating the expansion of the silicon material, thereby preventing damage to the overall structure of the composite material. Consequently, the structural integrity of the composite material is maintained during the complete lithium intercalation reaction of silicon, resulting in a notable improvement in the electrochemical performance of the battery. Moreover, in the case of multi-element composites, the presence of C and N is advantageous for enhancing the cycle performance of the material, while B and P help improve the rate capability of the material.

In a first aspect, an embodiment of the present invention provides a composite material for a secondary lithium-ion battery. The composite material is such that: the interior thereof is a spherical porous hard carbon material having hollow holes, and a product resulting from the decomposition and deposition of a silicon-containing gas and one or more gaseous compounds containing any element of C, N, B and P are deposited in the pores, wherein the product comprises silicon nanoparticles, and

the porous hard carbon material is obtained by means of curing a hard carbon matrix using a double emulsion method and then carbonizing same.

Preferably, the silicon content in the composite material is 1 wt%-70 wt%.

Preferably, the particle size of the composite material is 1 um-100 um, the average pore diameter of the pores is 0.1 nm-10 nm, and the size of the hollow holes is 0.5 um-80 um.

Preferably, the hard carbon matrix of the spherical porous hard carbon material is a combination of one or more of phenolic resin, epoxy resin, furfural resin or polybutadiene resin;
the silicon-containing gas is a silane compound, comprising a combination of one or more of silicane, trisilane, dichlorosilane, trichlorosilane and tetrachlorosilane;
the gaseous compounds containing the element C comprise one or more of acetylene, methane, propylene, ethylene, propane and gaseous ethanol;
the gaseous compounds containing the element N comprise one or more of nitrogen, ammonia, urea and melamine;
the gaseous compounds containing the element B comprise one or more of diborane, trimethyl borate, tripropyl borate and boron tribromide; and
the gaseous compounds containing the element P comprise phosphine and/or phosphorus oxychloride.

In a second aspect, an embodiment of the present invention provides a preparation method for the composite material for a secondary lithium-ion battery as described in the first aspect.

### The preparation method comprises:

Step 1, using pure oil as a first solution phase; dissolving resins in a corresponding solvent and adding a nonionic surfactant and a curing agent to prepare a second solution phase; using surfactant-containing oil as a third solution phase; slowly adding the first solution phase to the second solution phase, stirring for 0.5 hour -1 hour, then adding the well stirred mixture into the third solution phase, and stirring to obtain a desired emulsion; continuing stirring while heating to 80°C -130°C, and maintaining the temperature for 1 hour-24 hours until the resins are cured, forming hollow resin microspheres; and then centrifuging, washing, and drying the microspheres;
Step 2, placing the dried sample into a reaction unit and heating to 800°C -1300°C, and maintaining the temperature for 0.5 hour-15 hours for high-temperature carbonization treatment, resulting in a hard carbon matrix with a particle size range of 1 um-100 um;
Step 3, using a pore-generating gas source to perform pore formation treatment on the obtained hard carbon matrix at 600°C -1000°C for a duration of 1 hour-10 hours, resulting in a porous hard carbon matrix material, the pore-generating gas source being a combination of one or two of oxygen, carbon dioxide, and water vapor, and the gas flow rate of the pore-generating gas source being 2 L/min -20 L/min; and
Step 4, performing vapor deposition on the obtained porous hard carbon matrix material to obtain the composite material for a secondary lithium-ion battery, a gas source for the vapor deposition comprising a silicon-containing gas and one or more gaseous compounds containing any element of C, N, B and P.

Preferably, a protective gas for the vapor deposition is one or a combination of nitrogen or argon, and the flow rate is 1-5 L/min; and the gas flow rate of the gaseous compounds is 0.5-10 L/min, the flow rate of the silicon-containing gas is 0.5-10 L/min, the temperature of the vapor deposition is 500-1500°C, and the vapor deposition time is 1-20 hours.

Preferably, the resins comprise a combination of one or more of phenolic resin, epoxy resin, furfural resin or polybutadiene resin;
the solvent comprises a combination of one or more of ethanol, acetone and toluene;
the oil comprises a combination of one or more of vegetable oil, paraffin oil and mineral oil;
the nonionic surfactant comprises a combination of one or more of alkyl glucoside, fatty glyceride, fatty acid sorbitan and polysorbate;
the curing agent comprises a combination of one or more of trimethylhexamethyllenediamine, ethylenediamine and m-xylylenediamine;
the surfactant comprises a combination of one or more of stearic acid, sodium dodecyl benzene sulfonate and lecithin;
the silicon-containing gas is a silane compound, comprising a combination of one or more of silicane, trisilane, dichlorosilane, trichlorosilane and tetrachloro-silane;
the gaseous compounds containing the element C comprise one or more of acetylene, methane, propylene, ethylene, propane and gaseous ethanol;
the gaseous compounds containing the element N comprise one or more of nitrogen, ammonia, urea and melamine;
the gaseous compounds containing the element B comprise one or more of diborane, trimethyl borate, tripropyl borate and boron tribromide; and
the gaseous compounds containing the element P comprise phosphine and/or phosphorus oxychloride.

Preferably, by mass fraction, first solution phase: second solution phase: third solution phase=(0,30%]:(0,30%]:(0,50%];
in the second solution phase, by mass fraction, resins: solvent: curing agent: nonionic surfactant=(0,80%]:(0,90%]:[0,30%]:(0,20%]; and
in the third solution phase, by mass fraction, oil: surfactant=(0,90%]:(0,30%].

In a third aspect, an embodiment of the present invention provides a negative electrode material for a lithium battery, comprising the composite material for a secondary lithium-ion battery as described in the first aspect.

In a fourth aspect, an embodiment of the present invention provides a lithium-ion battery, comprising the composite material for a secondary lithium-ion battery as described in the first aspect.

According to the composite material for a secondary lithium-ion battery provided by the embodiment of the present invention, nano-silicon and one or more gaseous compounds containing any element of C, N, B and P are uniformly distributed in the pores of spherical porous carbon by vapor deposition. On one hand, the porous structure can limit the size and uniform dispersion of deposited nano-silicon particles, reduce the expansion effect and avoid the problem of electrical contact deterioration caused by silicon pulverization. On the other hand, the presence of large holes at the center provides a larger buffer space for accommodating the expansion of the silicon material, thereby preventing damage to the overall structure of the composite material. Consequently, the structural integrity of the composite material is maintained during the complete lithium intercalation reaction of silicon, resulting in a notable improvement in the electrochemical performance of the battery. Moreover, in the case of multi-element composites, the presence of C and N is advantageous for enhancing the cycle performance of the material, while B and P help improve the rate capability of the material. The composite material for a lithium-ion battery provided by the present invention can be used in liquid, semi-solid, quasi-solid and all-solid electrolyte lithium-ion batteries.

### BRIEF DESCRIPTION OF THE SEVERAL VIEWS OF THE DRAWINGS

The technical solutions of the embodiments of the present invention will be described in further detail with reference to the drawings and embodiments.
Fig. 1 is a flowchart of a preparation method for a composite material for a secondary lithium-ion battery provided by an embodiment of the present invention; and
Fig. 2 is a scanning electron microscope (SEM) diagram of a cross section of a composite material for a secondary lithium-ion battery prepared in Embodiment 1 of the present invention.

### DETAILED DESCRIPTION OF THE INVENTION

The present invention will be further explained below by referring to drawings and specific embodiments, but it should be understood that these embodiments are only for more detailed explanation, and should not be construed as limiting the present invention in any way, that is, not intended to limit the scope of protection of the present invention.

The present invention provides a composite material for a secondary lithium-ion battery. The interior of the composite material is a spherical porous hard carbon material having hollow holes, and a product resulting from the decomposition and deposition of a silicon-containing gas and one or more gaseous compounds containing any element of C, N, B and P are deposited in the pores, wherein the product comprises silicon nanoparticles, and

the porous hard carbon material is obtained by means of curing a hard carbon matrix using a double emulsion method and then carbonizing same. The hard carbon matrix is a combination of one or more of phenolic resin, epoxy resin, furfural resin or polybutadiene resin.

The silicon content in the composite material is 1 wt%-70 wt%.

The particle size of the composite material is 1 um-100 um, the average pore diameter of the pores is 0.1 nm-10 nm, and the size of the hollow holes inside is 0.5 um-80 um.

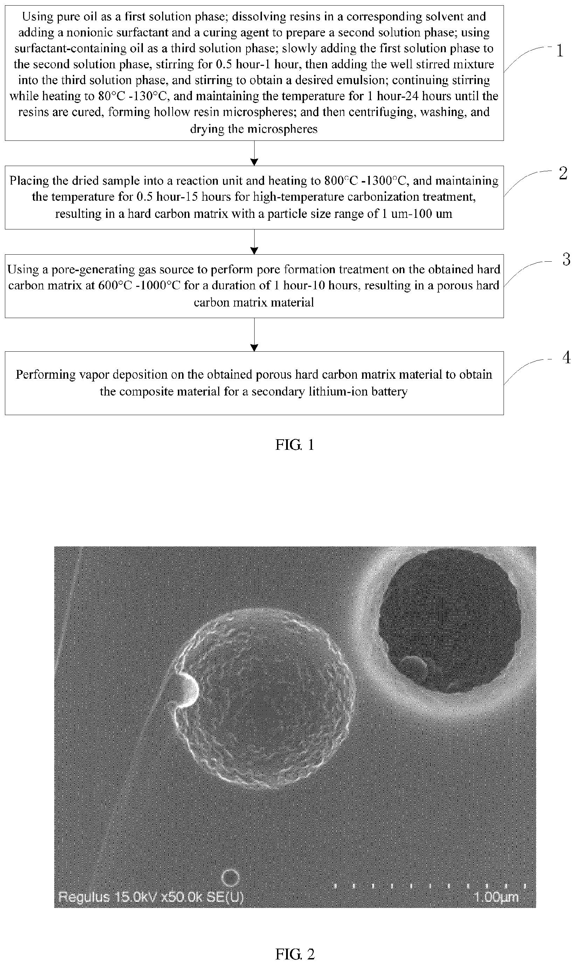

The preparation method of the above-mentioned composite material with hollow holes for a lithium battery is shown in Fig. 1, which comprises the following steps:
Step 1, using pure oil as a first solution phase; dissolving resins in a corresponding solvent and adding a nonionic surfactant and a curing agent to prepare a second solution phase; using surfactant-containing oil as a third solution phase; slowly adding the first solution phase to the second solution phase, stirring for 0.5 hour-1 hour, then adding the well stirred mixture into the third solution phase, and stirring to obtain a desired emulsion; continuing stirring while heating to 80°C -130°C, and maintaining the temperature for 1 hour-24 hours until the resins are cured, forming hollow resin microspheres; and then centrifuging, washing, and drying the microspheres;
   wherein the resins comprise a combination of one or more of phenolic resin, epoxy resin, furfural resin or polybutadiene resin; the solvent comprises a combination of one or more of ethanol, acetone and toluene;
   the oil comprises a combination of one or more of vegetable oil, paraffin oil and mineral oil; the nonionic surfactant comprises a combination of one or more of alkyl glucoside, fatty glyceride, fatty acid sorbitan and polysorbate; the curing agent comprises a combination of one or more of trimethylhexamethylenediamine, ethylenediamine and m-xylylenediamine; the surfactant comprises a combination of one or more of stearic acid, sodium dodecyl benzene sulfonate and lecithin;
   by mass fraction, first solution phase: second solution phase: third solution phase=(0,30%]:(0,30%]:(0,50%];
   in the second solution phase, by mass fraction, resins: solvent: curing agent: nonionic surfactant=(0,80%]:(0,90%]:[0,30%]:(0,20%]; and
   in the third solution phase, by mass fraction, oil: surfactant=(0,90%]:(0,30%];
Step 2, placing the dried sample into a reaction unit and heating to 800°C -1300°C, and maintaining the temperature for 0.5 hour-15 hours for high-temperature carbonization treatment, resulting in a hard carbon matrix with a particle size range of 1 um-100 um;
   wherein the reaction unit can be a common reaction unit such as a high-temperature reaction furnace;
Step 3, using a pore-generating gas source to perform pore formation treatment on the obtained hard carbon matrix at 600-1000°C for a duration of 1 hour-10 hours, resulting in a porous hard carbon matrix material,
   wherein the pore-generating gas source being a combination of one or two of oxygen, carbon dioxide, and water vapor, and the gas flow rate of the pore-generating gas source being 2 L/min -20 L/min; and
Step 4, performing vapor deposition on the obtained porous hard carbon matrix material to obtain the composite material for a secondary lithium-ion battery,

Wherein a gas source for the vapor deposition comprising a silicon-containing gas and one or more gaseous compounds containing any element of C, N, B and P.

A protective gas for the vapor deposition is one or a combination of nitrogen or argon, and the flow rate is 1-5 L/min: and the gas flow rate of the gaseous compounds is 0.5-10 L/min, the flow rate of the silicon-containing gas is 0.5-10 L/min, the temperature of the vapor deposition is 500-1500°C, and the vapor deposition time is 1-20 hours.

The silicon-containing gas is a silane compound, comprising a combination of one or more of silicane, trisilane, dichlorosilane, trichlorosilane and tetrachloro-silane;
the gaseous compounds containing the element C comprise one or more of acetylene, methane, propylene, ethylene, propane and gaseous ethanol;
the gaseous compounds containing the element N comprise one or more of nitrogen, ammonia, urea and melamine;
the gaseous compounds containing the element B comprise one or more of diborane, trimethyl borate, tripropyl borate and boron tribromide; and
the gaseous compounds containing the element P comprise phosphine and/or phosphorus oxychloride.

The composite material for a secondary lithium-ion battery provided by the present invention can be used as a negative electrode material for lithium-ion batteries.

In order to better understand the technical solutions provided by the present invention, the specific process of preparing the composite material for a secondary lithium-ion battery by the method provided in the above embodiment of the present invention, the method of its application in a lithium-ion secondary battery, and battery characteristics are described below with several specific examples.

### Embodiment 1

This embodiment provides a preparation method for a composite material for a secondary lithium-ion battery, comprising:
Step 1, using vegetable oil as a first solution phase; dissolving phenolic resin in ethanol and adding alkyl glucoside and ethylenediamine to prepare a second solution phase; using oil containing stearic acid as a third solution phase; slowly adding the first solution phase to the second solution phase, stirring for 1 hour, then adding the well stirred mixture into the third solution phase, and stirring to obtain a desired emulsion; continuing stirring while heating to 130°C, and maintaining the temperature for 1 hour until the resins are cured, forming hollow resin microspheres; and then centrifuging, washing, and drying the microspheres;
Step 2, placing the dried sample into a reaction unit and heating to 800°C, and maintaining the temperature for 0.5 hour for high-temperature carbonization treatment, resulting in a hard carbon matrix with a particle size of 10.8 um;
Step 3, performing pore formation treatment on the hard carbon matrix obtained in Step 2 by using oxygen as a gas source, the flow rate being 2 L/min, the pore formation temperature being 600°C, and the duration being 10 hours; and
Step 4, introducing nitrogen as a protective gas and/or carrier gas, flowing at a rate of 1 L/min, the porous carbon obtained in Step 3 as a substrate, silicane, a silicon-containing gas, as a silicon source, along with methane, a C-containing compound, into a reaction vessel in the form of gas, and performing vapor deposition, the gas flow rate of silicane being 0.5 L/min, the gas flow rate of methane being 0.5 L/min, the temperature of the vapor deposition being 500°C, and the vapor deposition time being 20 hours, so as to obtain the composite material for a secondary lithium-ion battery.

Fig. 2 is a SEM diagram of a cross section of the composite material for a secondary lithium-ion battery prepared in Embodiment 1 of the present invention. From the SEM diagram of the cross section, it can be seen that the central region of the material contains large holes, which, in addition to the abundant pores, provide a larger buffering space for silicon expansion.

### The obtained material was used as a negative electrode material.

The obtained negative electrode material, carbon black serving as a conductive additive, and a binder (sodium carboxymethyl cellulose and butadiene styrene rubber in a 1:1 ratio) were weighed according to the ratio of 95:2:3, and slurry was prepared in a beater at room temperature. The prepared slurry was evenly applied to copper foil. After being dried in a blast drying oven at 50°C for 2 hours, the dried copper foil was cut into 8×8 mm pole pieces, and then vacuum drying was performed in a vacuum drying oven at 100°C for 10 hours. The dried pole pieces were immediately transferred into a glove box for battery assembly.

Simulated battery assembly was performed in a glove box containing high purity Ar atmosphere, with lithium metal serving as a counter electrode and a solution of ethylene carbonate (EC)/dimethyl carbonate (DMC) containing 1 mol LiPF₆ as an electrolyte. A constant current charge-discharge mode test was carried out by using a charge-discharge instrument. The discharge cut-off voltage was 0.005 V and the charge cut-off voltage was 1.5 V. The charge-discharge test was carried out at C/10 current density. The test results are recorded in Table 1.

### Embodiment 2

This embodiment provides a preparation method for a composite material for a secondary lithium-ion battery, comprising:
Step 1, using vegetable oil as a first solution phase; dissolving phenolic resin in ethanol and adding alkyl glucoside and ethylenediamine to prepare a second solution phase; using oil containing stearic acid as a third solution phase; slowly adding the first solution phase to the second solution phase, stirring for 1 hour, then adding the well stirred mixture into the third solution phase, and stirring to obtain a desired emulsion; continuing stirring while heating to 80°C, and maintaining the temperature for 24 hours until the resins are cured, forming hollow resin microspheres; and then centrifuging, washing, and drying the microspheres;
Step 2, placing the dried sample into a reaction unit and heating to 1300°C, and maintaining the temperature for 0.5 hour for high-temperature carbonization treatment, resulting in a hard carbon matrix with a particle size of 12.1 um;
Step 3, performing pore formation treatment on the hard carbon matrix obtained in Step 2 by using a combination of carbon dioxide and water vapor as a gas source, the flow rate being 20 L/min, the pore formation temperature being 1000°C, and the duration being 1 hour; and
Step 4, introducing argon as a protective gas and/or carrier gas, flowing at a rate of 1.5 L/min, the porous carbon obtained in Step 3 as a substrate,trisilane, a silicon-containing gas, as a silicon source, along with ammonia, an N-containing compound, into a reaction vessel in the form of gas, and performing vapor deposition, the gas flow rate of trisilane being 0.8 L/min, the gas flow rate of ammonia being 0.8 L/min, the temperature of the vapor deposition being 600°C, and the vapor deposition time being 12.5 hours.

Button batteries were assembled according to the method described in Embodiment 1 above, and their electrochemical performance was evaluated under the same testing conditions. The test results are recorded in Table 1.

### Embodiment 3

This embodiment provides a preparation method for a composite material for a secondary lithium-ion battery, comprising:
Step 1, using mineral oil as a first solution phase; dissolving phenolic resin in ethanol and adding alkyl glucoside and m-xylylenediamine to prepare a second solution phase; using oil containing stearic acid as a third solution phase; slowly adding the first solution phase to the second solution phase, stirring for 3 hours, then adding the well stirred mixture into the third solution phase, and stirring to obtain a desired emulsion; continuing stirring while heating to 100°C, and maintaining the temperature for 4 hours until the resins are cured, forming hollow resin microspheres; and then centrifuging, washing, and drying the microspheres;
Step 2, placing the dried sample into a reaction unit and heating to 800°C, and maintaining the temperature for 5 hours for high-temperature carbonization treatment, resulting in a hard carbon matrix with a particle size of 13.5 um;
Step 3, performing pore formation treatment on the hard carbon matrix obtained in Step 2 by using water vapor as a gas source, the flow rate being 2 L/min, the pore formation temperature being 1000°C, and the duration being 10 hours; and
Step 4, introducing nitrogen as a protective gas and/or carrier gas, flowing at a rate of 2 L/min, the porous carbon obtained in Step 3 as a substrate,dichlorosilane, a silicon-containing gas, as a silicon source, along with tripropyl borate, a B-containing compound, into a reaction vessel in the form of gas, and performing vapor deposition, the gas flow rate of dichlorosilane being 1 L/min, the gas flow rate of tripropyl borate being 1 L/min, the temperature of the vapor deposition being 700°C, and the vapor deposition time being 10 hours.

Button batteries were assembled according to the method described in Embodiment 1 above, and their electrochemical performance was evaluated under the same testing conditions. The test results are recorded in Table 1.

### Embodiment 4

This embodiment provides a preparation method for a composite material for a secondary lithium-ion battery, comprising:
Step 1, using vegetable oil as a first solution phase; dissolving phenolic resin in ethanol and adding alkyl glucoside and ethylenediamine to prepare a second solution phase; using oil containing stearic acid as a third solution phase; slowly adding the first solution phase to the second solution phase, stirring for 1 hour, then adding the well stirred mixture into the third solution phase, and stirring to obtain a desired emulsion; continuing stirring while heating to 130°C, and maintaining the temperature for 5 hours until the resins are cured, forming hollow resin microspheres; and then centrifuging, washing, and drying the microspheres;
Step 2, placing the dried sample into a reaction unit and heating to 1000°C, and maintaining the temperature for 6 hours for high-temperature carbonization treatment, resulting in a hard carbon matrix with a particle size of 9.2 um;
Step 3, performing pore formation treatment on the hard carbon matrix obtained in Step 2 by using carbon dioxide as a gas source, the flow rate being 2 L/min, the pore formation temperature being 950°C, and the duration being 6 hours; and
Step 4, introducing argon as a protective gas and/or carrier gas, flowing at a rate of 2.5 L/min, the porous carbon obtained in Step 3 as a substrate, trichlorosilane, a silicon-containing gas, as a silicon source, along with phosphorus oxychloride, a P-containing compound into a reaction vessel in the form of gas, and performing vapor deposition, wherein the gas flow rate of trichlorosilane being 1.25 L/min, the gas flow rate of the gaseous compound phosphorus oxychloride being 1.25 L/min, the temperature of the vapor deposition being 800°C, and the vapor deposition time being 8 hours.

Button batteries were assembled according to the method described in Embodiment 1 above, and their electrochemical performance was evaluated under the same testing conditions. The test results are recorded in Table 1.

### Embodiment 5

This embodiment provides a preparation method for a composite material for a secondary lithium-ion battery, comprising:
Step 1, using paraffin oil as a first solution phase; dissolving phenolic resin in ethanol and adding alkyl glucoside and ethylenediamine to prepare a second solution phase; using oil containing stearic acid as a third solution phase; slowly adding the first solution phase to the second solution phase, stirring for 1 hour, then adding the well stirred mixture into the third solution phase, and stirring to obtain a desired emulsion; continuing stirring while heating to 130°C, and maintaining the temperature for 10 hours until the resins are cured, forming hollow resin microspheres; and then centrifuging, washing, and drying the microspheres;
Step 2, placing the dried sample into a reaction unit and heating to 800°C, and maintaining the temperature for 2 hours for high-temperature carbonization treatment, resulting in a hard carbon matrix with a particle size of 15.1 um;
Step 3, performing pore formation treatment on the hard carbon matrix obtained in Step 2 by using carbon dioxide as a gas source, the flow rate being 5 L/min, the pore formation temperature being 800°C, and the duration being 2 hours; and
Step 4, introducing nitrogen as a protective gas and/or carrier gas, flowing at a rate of 3 L/min, the porous carbon obtained in Step 3 as a substrate, tetrachlorosilane, a silicon-containing gas, as a silicon source , along with gaseous compounds containing elements of C, N, B and P methane, ammonia, trimethyl borate and phosphorus oxychloride into a reaction vessel in the form of gas, and performing vapor deposition, wherein the gas flow rate of tetrachlorosilane being 2 L/min, the gas flow rate of the gaseous compounds methane, ammonia, trimethyl borate and phosphorus oxychloride being 0.5 L/min, the temperature of the vapor deposition being 900°C, and the vapor deposition time being 5 hours.

Button batteries were assembled according to the method described in Embodiment 1 above, and their electrochemical performance was evaluated under the same testing conditions. The test results are recorded in Table 1.

### Embodiment 6

This embodiment provides a preparation method for a composite material for a secondary lithium-ion battery, comprising:
Step 1, using vegetable oil as a first solution phase; dissolving phenolic resin in ethanol and adding alkyl glucoside and ethylenediamine to prepare a second solution phase; using oil containing stearic acid as a third solution phase; slowly adding the first solution phase to the second solution phase, stirring for 1 hour, then adding the well stirred mixture into the third solution phase, and stirring to obtain a desired emulsion; continuing stirring while heating to 130°C, and maintaining the temperature for 14 hours until the resins are cured, forming hollow resin microspheres; and then centrifuging, washing, and drying the microspheres;
Step 2, placing the dried sample into a reaction unit and heating to 1300°C, and maintaining the temperature for 2 hours for high-temperature carbonization treatment, resulting in a hard carbon matrix with a particle size of 8.5 um;
Step 3, performing pore formation treatment on the hard carbon matrix obtained in Step 2 by using oxygen as a gas source, the flow rate being 2 L/min, the pore formation temperature being 900°C, and the duration being 2 hours; and
Step 4, introducing argon as a protective gas and/or carrier gas, flowing at a rate of 3.5 L/min, the porous carbon obtained in Step 3 as a substrate, silicane and trisilane, silicon-containing gases, as a silicon source, along with gaseous compounds containing chemical elements C, N, B and P propylene, urea, tripropyl borate and phosphine, into a reaction vessel in the form of gas, and performing vapor deposition, the gas flow rate of silicane and trisilane being 1.25 L/min, the gas flow rate of the gaseous compounds propylene, urea, tripropyl borate and phosphine being 0.6 L/min, the temperature of the vapor deposition being 1000°C, and the vapor deposition time being 4 hours.

Button batteries were assembled according to the method described in Embodiment 1 above, and their electrochemical performance was evaluated under the same testing conditions. The test results are recorded in Table 1.

### Embodiment 7

This embodiment provides a preparation method for a composite material for a secondary lithium-ion battery, comprising:
Step 1, using vegetable oil as a first solution phase; dissolving phenolic resin in ethanol and adding polysorbate and m-xylylenediamine to prepare a second solution phase; using oil containing stearic acid as a third solution phase; slowly adding the first solution phase to the second solution phase, stirring for 1 hours, then adding the well stirred mixture into the third solution phase, and stirring to obtain a desired emulsion; continuing stirring while heating to 130°C, and maintaining the temperature for 5 hours until the resins are cured, forming hollow resin microspheres; and then centrifuging, washing, and drying the microspheres;
Step 2, placing the dried sample into a reaction unit and heating to 900°C, and maintaining the temperature for 2 hours for high-temperature carbonization treatment, resulting in a hard carbon matrix with a particle size of 13.8 um;
Step 3, performing pore formation treatment on the hard carbon matrix obtained in Step 2 by using a combination of one or two of oxygen, carbon dioxide and water vapor as a gas source, the pore formation temperature being 1000°C, and the duration being 5 hours; and
Step 4, introducing nitrogen as a protective gas and/or carrier gas, flowing at a rate of 4 L/min, the porous carbon obtained in Step 3 as a substrate, silicane, trisilane and dichlorosilane, silicon-containing gases, as a silicon source, along with compounds containing chemical elements C, N, B and P ,propane, hydrazine, diborane and phosphine, into a reaction vessel in the form of gas, and performing vapor deposition, the gas flow rate of silicane, trisilane and dichlorosilane being 1.3 L/min, the gas flow rate of propane, hydrazine, diborane and phosphine being 0.5 L/min, the temperature of the vapor deposition being 1100°C, and the vapor deposition time being 2.5 hours.

Button batteries were assembled according to the method described in Embodiment 1 above, and their electrochemical performance was evaluated under the same testing conditions. The test results are recorded in Table 1.

### Embodiment 8

This embodiment provides a preparation method for a composite material for a secondary lithium-ion battery, comprising:
Step 1, using vegetable oil as a first solution phase; dissolving phenolic resin in ethanol and adding fatty glyceride and ethylenediamine to prepare a second solution phase; using oil containing stearic acid as a third solution phase; slowly adding the first solution phase to the second solution phase, stirring for 1 hour, then adding the well stirred mixture into the third solution phase, and stirring to obtain a desired emulsion; continuing stirring while heating to 80°C -130°C, and maintaining the temperature for 12 hours until the resins are cured, forming hollow resin microspheres; and then centrifuging, washing, and drying the microspheres;
Step 2, placing the dried sample into a reaction unit and heating to 1200°C, and maintaining the temperature for 5 hours for high-temperature carbonization treatment, resulting in a hard carbon matrix with a particle size of 15.8 um;
Step 3, performing pore formation treatment on the hard carbon matrix obtained in Step 2 by using water vapor as a gas source, the flow rate being 5 L/min, the pore formation temperature being 1000°C, and the duration being 1.5 hours; and
Step 4, introducing argon as a protective gas and/or carrier gas, flowing at a rate of 4.5 L/min, the porous carbon obtained in Step 3 as a substrate, silicane, trisilane and trichlorosilane, silicon-containing gases , as a silicon source , along with compounds containing elements C, N, B and P including ethanol, nitrogen, trimethyl borate and phosphorus oxychloride into a reaction vessel in the form of gasand performing vapor deposition, the gas flow rate of silicane, trisilane and trichlorosilane being 1.7 L/min, the gas flow rate of the gaseous compounds ethanol, nitrogen, trimethyl borate and phosphorus oxychloride being 1.25 L/min, the temperature of the vapor deposition being 1200°C, and the deposition time being 2 hours.

Button batteries were assembled according to the method described in Embodiment 1 above, and their electrochemical performance was evaluated under the same testing conditions. The test results are recorded in Table 1.

### Embodiment 9

This embodiment provides a preparation method for a composite material for a secondary lithium-ion battery, comprising:
Step 1, using vegetable oil as a first solution phase; dissolving phenolic resin in ethanol and adding alkyl glucoside and trimethylhexamethylenediamine to prepare a second solution phase; using oil containing sodium dodecyl benzene sulfonate as a third solution phase; slowly adding the first solution phase to the second solution phase, stirring for 1 hour, then adding the well stirred mixture into the third solution phase, and stirring to obtain a desired emulsion; continuing stirring while heating to 100°C, and maintaining the temperature for 6 hours until the resins are cured, forming hollow resin microspheres; and then centrifuging, washing, and drying the microspheres;
Step 2, placing the dried sample into a reaction unit and heating to 900°C, and maintaining the temperature for 6 hours for high-temperature carbonization treatment, resulting in a hard carbon matrix with a particle size of 14.5 um;
Step 3, performing pore formation treatment on the hard carbon matrix obtained in Step 2 by using carbon dioxide as a gas source, the flow rate being 10 L/min, the pore formation temperature being 1000°C, and the duration being 1 hour; and
Step 4, introducing nitrogen as a protective gas and/or carrier gas, flowing at a rate of 5 L/min, the porous carbon obtained in Step 3 as a substrate, trisilane, dichlorosilane and trichlorosilane, silicon-containing gases, as a silicon source , along with compounds containing chemical elements C, N, B and P, ethylene, propane, urea, melamine, tripropyl borate, boron tribromide, phosphine and phosphorus oxychloride into a reaction vessel in the form of gas , and performing vapor deposition, the gas flow rate of trisilane, dichlorosilane and trichlorosilane being 2.7 L/min, the gas flow rate of the gaseous compounds ethylene, propane, urea, melamine, tripropyl borate, boron tribromide, phosphine and phosphorus oxychloride being 1 L/min, the temperature of the vapor deposition being 1400°C, and the vapor deposition time being 1.25 hours.

Button batteries were assembled according to the method described in Embodiment 1 above, and their electrochemical performance was evaluated under the same testing conditions. The test results are recorded in Table 1.

### Embodiment 10

This embodiment provides a preparation method for a composite material for a secondary lithium-ion battery, comprising:
Step 1, using vegetable oil as a first solution phase; dissolving phenolic resin in ethanol and adding alkyl glucoside and ethylenediamine to prepare a second solution phase; using oil containing stearic acid as a third solution phase; slowly adding the first solution phase to the second solution phase, stirring for 1 hour, then adding the well stirred mixture into the third solution phase, and stirring to obtain a desired emulsion; continuing stirring while heating to 130°C, and maintaining the temperature for 2 hours until the resins are cured, forming hollow resin microspheres; and then centrifuging, washing, and drying the microspheres;
Step 2, placing the dried sample into a reaction unit and heating to 900°C, and maintaining the temperature at 1000°C for 6 hours for high-temperature carbonization treatment, resulting in a hard carbon matrix with a particle size of 16.2 um;
Step 3, performing pore formation treatment on the hard carbon matrix obtained in Step 2 by using a combination of one or two of oxygen, carbon dioxide and water vapor as a gas source, the pore formation temperature being 800°C, and the duration being 5 hours; and
Step 4, introducing argon as a protective gas and/or carrier gas, flowing at a rate of 5 L/min, the porous carbon obtained in Step 3 as a substrate, dichlorosilane, trichlorosilane and tetrachlorosilane, silicon-containing gases as a silicon source, along with compounds containing elements C, N, B and P acetylene, propane, ammonia, hydrazine, tripropyl borate, boron tribromide, phosphine and phosphorus oxychloride into a reaction vessel in the form of gas, and performing vapor deposition, the gas flow rate of dichlorosilane, trichlorosilane and tetrachlorosilane being 3.3 L/min, the gas flow rate of the gaseous compounds acetylene, propane, ammonia, hydrazine, tripropyl borate, boron tribromide, phosphine and phosphorus oxychloride being 1.3 L/min, the temperature of the vapor deposition being 1500°C, and the vapor deposition time being 1 hour.

Button batteries were assembled according to the method described in Embodiment 1 above, and their electrochemical performance was evaluated under the same testing conditions. The test results are recorded in Table 1.

To facilitate comparison, we prepared a control sample using the following method.

### Comparative example 1

This comparative example provides a preparation method for a silicon-carbon composite material in the prior art, comprising the following steps:
(1) in an ethanol system, adding silicon particles, the carbon source precursor polyvinylpyrrolidone, graphite and the antioxidant citric acid according to the mass ratio of 1:1:1:0.1, and performing sanding to obtain a dispersion liquid;
(2) spray-drying the dispersion liquid to obtain silicon-carbon powder; and
(3) performing gas phase coating on the powder to obtain the silicon-carbon composite material.

Button batteries were assembled according to the method described in Embodiment 1 above, and their electrochemical performance was evaluated under the same testing conditions. The test results are recorded in Table 1.

**Table 1**

| No. | Charge specific capacity (mAh/g) | First-cycle efficiency (%) |
|---|---|---|
| Embodiment 1 | 1437 | 89.68 |
| Embodiment 2 | 1432 | 89.79 |
| Embodiment 3 | 1427 | 90.12 |
| Embodiment 4 | 1425 | 90.54 |
| Embodiment 5 | 1424 | 90.31 |
| Embodiment 6 | 1418 | 89.80 |
| Embodiment 7 | 1413 | 89.50 |
| Embodiment 8 | 1409 | 89.41 |
| Embodiment 9 | 1414 | 89.39 |
| Embodiment 10 | 1392 | 83.43 |
| Comparative example 1 | 1212 | 78.92 |

By comparing the comparative example with the embodiments, it can be seen that the silicon-containing porous hollow hard carbon composite material provided by the present invention has higher specific capacity and first-cycle efficiency. Furthermore, the present invention further enhances the first-cycle efficiency of the material by regulating the deposition time, temperature, and gas flow rate. The present invention scientifically sets the gas flow rate and temperature during preparation, thus preventing rapid decomposition of silane and direct deposition onto the carbon matrix surface caused by excessively high gas flow rate and temperature, which affects battery performance. Additionally, it avoids incomplete decomposition of silane caused by excessively low temperature, which affects the capacity of batteries.

According to the composite material for a secondary lithium-ion battery provided by the embodiment of the present invention, nano-silicon and one or more gaseous compounds containing any element of C, N, B and P are uniformly distributed in the pores of spherical porous carbon by vapor deposition. On one hand, the porous structure can limit the size and uniform dispersion of deposited nano-silicon particles, reduce the expansion effects and avoid the problem of electrical contact deterioration caused by silicon pulverization. On the other hand, the presence of large holes at the center provides a substantial buffer space for accommodating the expansion of the silicon material, thereby preventing damage to the overall structure of the composite material. Consequently, the structural integrity of the composite material is maintained during the complete lithium intercalation reaction of silicon, resulting in a notable improvement in the electrochemical performance of the battery. Moreover, the utilization of multi-element composites leads to further improvement of the specific capacity and first-cycle efficiency of the material.

The above-mentioned specific embodiments further explain the purpose, technical solution and beneficial effects of the present invention in detail. It should be understood that the above are only specific embodiments of the present invention and are not used to limit the scope of protection of the present invention. Any modification, equivalent substitution, improvement, etc. made within the spirit and principles of the present invention should be included in the scope of protection of the present invention.

## Claims

1. A composite material for a secondary lithium-ion battery, wherein the interior of the composite material isa spherical porous hard carbon material having hollow holes, and a product resulting from the decomposition and deposition of a silicon-containing gas and one or more gaseous compounds containing any chemical elements of carbon C, nitrogen N, boron B and phosphorus P are deposited in the pores, and the product comprises silicon nano particles; and
the porous hard carbon material is obtained by means of curing a hard carbon matrix using a double emulsion method and then carbonizing same.

2. The composite material according to Claim 1, wherein the silicon content in the composite material is 1 wt%-70 wt%.

3. The composite material according to Claim 1, wherein the particle size of the composite material is 1um -100 um, the average pore diameter of the pores is 0.1 nm-10 nm, and the size of the hollow holes is 0.5 um-80 um.

4. The composite material according to Claim 1, wherein the hard carbon matrix of the spherical porous hard carbon material is a combination of one or more of phenolic resin, epoxy resin, furfural resin or polybutadiene resin;
the silicon-containing gas is a silane compound, comprising a combination of one or more of silicane, trisilane, dichlorosilane, trichlorosilane and tetrachlorosilane;
the gaseous compounds containing the element C comprise one or more of acetylene, methane, propylene, ethylene, propane and gaseous ethanol;
the gaseous compounds containing the element N comprise one or more of nitrogen, ammonia, urea and melamine;
the gaseous compounds containing the element B comprise one or more of diborane, trimethyl borate, tripropyl borate and boron tribromide; and
the gaseous compounds containing the element P comprise phosphine and/or phosphorus oxychloride.

5. A preparation method for the composite material for a secondary lithium-ion battery according to any one of Claims 1-4, comprising:
Step 1, using pure oil as a first solution phase; dissolving resins in a corresponding solvent and adding a nonionic surfactant and a curing agent to prepare a second solution phase; using surfactant-containing oil as a third solution phase; slowly adding the first solution phase to the second solution phase, stirring for 0.5 hour-1 hour, then adding the well stirred mixture into the third solution phase, and stirring to obtain a desired emulsion; continuing stirring while heating to 80°C -130°C, and maintaining the temperature for 1 hour-24 hours until the resins are cured, forming hollow resin microspheres; and then centrifuging, washing, and drying the microspheres;
Step 2, placing the dried sample into a reaction unit and heating to 800°C -1300°C, and maintaining the temperature for 0.5 hour-15 hours for high-temperature carbonization treatment, resulting in a hard carbon matrix with a particle size range of 1 um-100 um;
Step 3, using a pore-generating gas source to perform pore formation treatment on the obtained hard carbon matrix at 600°C -1000°C for a duration of 1 hour-10 hours, resulting in a porous hard carbon matrix material, the pore-generating gas source being a combination of one or two of oxygen, carbon dioxide, and water vapor, and the gas flow rate of the pore-generating gas source being 2 L/min -20 L/min; and
Step 4, performing vapor deposition on the obtained porous hard carbon matrix material to obtain the composite material for a secondary lithium-ion battery, a gas source for the vapor deposition comprising a silicon-containing gas and one or more gaseous compounds containing any element of C, N, B and P.

6. The preparation method according to Claim 5, wherein a protective gas for the vapor deposition is one or a combination of nitrogen or argon, and the flow rate is 1-5 L/min; and the gas flow rate of the gaseous compounds is 0.5-10 L/min, the flow rate of the silicon-containing gas is 0.5-10 L/min, the temperature of the vapor deposition is 500-1500°C, and the vapor deposition time is 1-20 hours.

7. The preparation method according to Claim 5, wherein the resins comprise a combination of one or more of phenolic resin, epoxy resin, furfural resin or polybutadiene resin;
the solvent comprises a combination of one or more of ethanol, acetone and toluene;
the oil comprises a combination of one or more of vegetable oil, paraffin oil and mineral oil;
the nonionic surfactant comprises a combination of one or more of alkyl glucoside, fatty glyceride, fatty acid sorbitan and polysorbate;
the curing agent comprises a combination of one or more of trimethylhexamethylenediamine, ethylenediamine and m-xylylenediamine;
the surfactant comprises a combination of one or more of stearic acid, sodium dodecyl benzene sulfonate and lecithin;
the silicon-containing gas is a silane compound, comprising a combination of one or more of silicane, trisilane, dichlorosilane, trichlorosilane and tetrachloro-silane;
the gaseous compounds containing the element C comprise one or more of acetylene, methane, propylene, ethylene, propane and gaseous ethanol;
the gaseous compounds containing the element N comprise one or more of nitrogen, ammonia, urea and melamine;
the gaseous compounds containing the element B comprise one or more of diborane, trimethyl borate, tripropyl borate and boron tribromide; and
the gaseous compounds containing the element P comprise phosphine and/or phosphorus oxychloride.

8. The preparation method according to Claim 5, wherein
by mass fraction, first solution phase: second solution phase: third solution phase=(0,30%]:(0,30%]:(0,50%];
in the second solution phase, by mass fraction, resins: solvent: curing agent: nonionic surfactant=(0,80%]:(0,90%]:[0,30%]:(0,20%]; and
in the third solution phase, by mass fraction, oil: surfactant=(0,90%]:(0,30%].

9. A negative electrode material for a lithium-ion battery, comprising the composite material for a secondary lithium-ion battery according to any one of Claims 1-4.

10. A lithium-ion battery, comprising the composite material for a secondary lithium-ion battery according to any one of Claims 1-4.
